# EUROPEAN PATENT APPLICATION

(11) **EP 4 177 805 A1**
(43) Date of publication of application: **10.05.2023**
(21) Application number: 22203646.9
(22) Date of filing: 25.10.2022
(51) Int. Cl.: G06Q 10/063, G06Q 50/06

(54) **DISPLAY UNIT**

(30) Priority: 09.11.2021 JP 2021182680
(71) Applicant: Yanmar Holdings Co., Ltd., Osaka-shi, Osaka (JP)
(72) Inventor: SASAKI, Tsubasa, Osaka (JP); TOGASHI, Taichi, Osaka (JP)
(74) Representative: Novagraaf International SA

(57) **Abstract**

[Problem]

To provide a technology that can improve a user's convenience in a display unit possessed by a management system that manages energy.

[Solution]

An exemplary display unit is a display unit possessed by a management system that manages energy, wherein plural pieces of information in the management system and related to power and heat are displayed on a single screen.

## Description

### TECHNICAL FIELD

The present invention relates to a display unit.

### BACKGROUND ART

Conventionally, an electric/heat energy network is known in which electric energy and heat energy are fused together (see, for example, Patent Document 1). The electric/heat energy network connects, for example, a cogeneration system, a renewable energy source, an electricity storage portion, a heat storage portion, a power supply network, a heat energy supply system, a power load, and a heat load. Optimization of an energy management of the electric/heat energy network is executed by a control unit (computer).

### PRIOR ART DOCUMENT

### PATENT DOCUMENT

Patent Document 1: Japanese Patent No. 6423967

### SUMMARY OF INVENTION

### TECHNICAL PROBLEM

The control unit for the energy management of the electric/heat energy network is equipped with an input unit and a display unit as man-machine interfaces. The display unit shows various entry screens, etc. There are many devices connected to an electric/heat energy network, and the information volume displayed on the display unit can easily become large. Due to this, the display unit of the management system that performs an energy management is required to display information in an organized and easy-to-read manner.

An object of the present invention is to provide a technology that can improve a user's convenience in a display unit possessed by a management system that manages energy.

### SOLUTION TO PROBLEM

An exemplary display unit of the present invention is a display unit possessed by a management system that manages energy, wherein plural pieces of information in the management system and related to power and heat are displayed on a single screen.

### ADVANTAGEOUS EFFECTS OF INVENTION

The exemplary present invention can improve a user's convenience in a display unit possessed by a management system that manages energy.

### BRIEF DESCRIPTION OF DRAWINGS

Fig. 1 is an image diagram of a management system.
Fig. 2 is a block diagram of a system controller.
Fig. 3 is a schematic diagram showing a state of displaying a login screen on a screen of a display unit.
Fig. 4 is a schematic diagram showing a state of displaying a home screen on the screen of the display unit.
Fig. 5 explains details of graph information displayed in each display area.
Fig. 6 explains about an operation of a display switch button displayed in a heat output display area.
Fig. 7 is a schematic diagram to explain about a home screen of a modified example.
Fig. 8 is a schematic diagram to explain about a home screen of another modified example.

### DESCRIPTION OF EMBODIMENTS

The following is a detailed description of an exemplary embodiment of the present invention with reference to the drawings.

### <1. Management System>

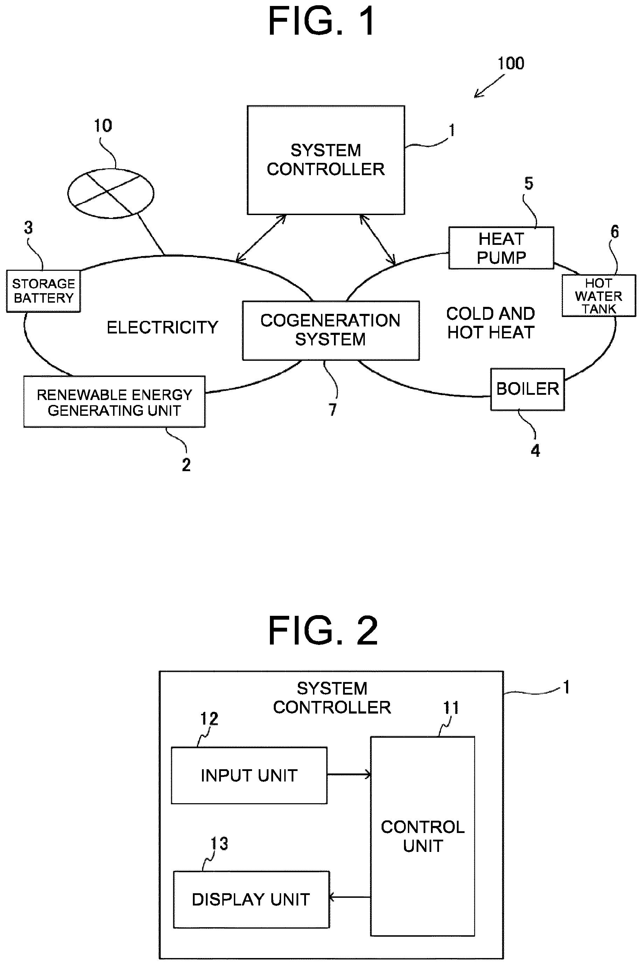

Fig. 1 is an image diagram of a management system 100 according to an embodiment of the present invention. The management system 100 manages energy. That is, the management system 100 is an energy management system. In detail, the management system 100 manages electric energy and heat energy. The management system 100 is applied, for example, to a residential facility, an industrial facility, or a residential/industrial facility.

As shown in Fig. 1, the management system 100 includes a system controller 1. The management system 100 manages electric energy and heat energy, centered on the system controller 1. The management system 100 includes a facility that is so provided as to supply electric power (electricity-related facility) and a facility that is so provided as to supply at least one of hot heat and cold heat (heat-related facility). These facilities are controlled by the system controller 1.

Note that the hot heat refers to heat that is hot, and the cold heat refers to heat that is cold. That is, when the heat is distinguished into hot heat and cold heat, the hot heat is hot heat and the cold heat is cold heat. For example, the hot heat is air with a higher temperature compared to the room temperature, and the cold heat is air with a lower temperature compared to the room temperature. The facilities shown in Fig. 1 are merely an exemplification and may be changed to a configuration lacking any of the facilities shown in Fig. 1 or to a configuration with an additional facility not shown in Fig. 1.

In the example shown in Fig. 1, the management system 100 includes a renewable energy generating unit 2 and a storage battery 3 each as the electricity-related facility described above. The renewable energy generating unit 2 and the storage battery 3 operate under the control of the system controller 1.

The renewable energy generating unit 2 is a unit that generates electricity using renewable energy such as solar light, wind power, hydraulic power, and geothermal power, for example. The renewable energy generating unit 2 may be, for example, a solar power or wind power generating unit. To a power supply line of the management system 100, the renewable energy generating unit 2 can supply the power obtained from the power generation. The storage battery 3 stores power generated by a power generation facility such as the renewable energy generating unit 2, for example, and discharges the stored power as needed. That is, the storage battery 3 can supply power to the power supply line of the management system 100. The storage battery 3 may be, for example, a lithium-ion battery.

The management system 100 is connected to a power system 10. The power system 10 is a large commercial power system that supplies power to a power-receiving facility of the management system 100. The management system 100 can purchase electricity from the power system 10 and receive the power supply. The system controller 1 is so provided as to control whether or not to receive power supply from the power system 10. The system controller 1 may be so provided as to control whether or not power is supplied to the power system 10.

In the example shown in Fig. 1, the management system 100 includes, as the heat-related facilities described above, a boiler 4, a heat pump 5, and a hot water tank 6. The boiler 4, the heat pump 5, and the hot water tank 6 operate under the control of the system controller 1.

To a heat supply line of the management system 100, the boiler 4 can supply the steam or hot water's heat energy obtained by combustion of gas or other fuels. Th heat pump 5 operates an engine fueled by a gas fuel or the like thereby to drive a compression unit for compressing a refrigerant, providing temperature control by the condensation or evaporation heat of the refrigerant. Here, the temperature control is, for example, the temperature control of the air in a room, etc. when the heat pump 5 is applied to an air conditioner, or the temperature control of a chiller circulating liquid when the heat pump 5 is applied to a chiller. The circulating liquid is typically water as an exemplification. The heat pump 5 can perform cooling operation to cool the temperature-controlled object and heating operation to heat the temperature-controlled object. That is, the heat pump 5 can switch between hot heat and cold heat, and supply the hot heat or the cold heat to the heat supply line of the management system 100. The hot water tank 6 is connected to the boiler 4, etc. and is capable of exchanging the water medium in the tank to hot water and storing hot heat. The heat stored in the hot water tank 6 can be supplied to the heat supply line of the management system 100.

In the example shown in Fig. 1, the management system 100 includes a cogeneration system 7 as a facility that is commonly used for the electricity-related facility and heat-related facility described above. The cogeneration system 7 operate under the control of the system controller 1. The cogeneration system 7 uses gas fuel or the like thereby to drive the engine, and generates electricity using a generator that is operated by the driving of the engine. The power generated by the generator can be supplied to the power supply line of the management system 100. To the heat supply line of the management system 100, the cogeneration system 7 can supply the steam or hot water's heat energy obtained by a waste heat recovery boiler that uses the heat (waste heat) generated by the engine.

To a power load included in the management system 100, power is supplied from the renewable energy generating unit 2, the storage battery 3, the power system 10, or the cogeneration system 7. The power load includes, for example, an electric light and various types of electric devices. To a heat load included in the management system 100, the hot heat or cold heat from the boiler 4, the heat pump 5, the hot water tank 6, or the cogeneration system 7 is supplied. The heat load includes, for example, a cooling unit, a heating unit, a refrigerator, a freezer, a hot water tank, etc.

### <2. System Controller>

Fig. 2 is a block diagram of the system controller 1 according to the embodiment of the present invention. As shown in Fig. 2, the system controller 1 has a control unit 11, an input unit 12, and a display unit 13. That is, the management system 100 has the display unit 13. The management system 100 further has the control unit 11 and the input unit 12.

The control unit 11 controls the entire management system 100. The control unit 11 is so configured as to include an arithmetic operation integrated circuit such as a CPU, a RAM (Random Access Memory), a ROM (Read Only Memory), etc. With the arithmetic operation integrated circuit such as the CPU executing an arithmetic processing that accords to a computer program stored in a memory such as ROM, the control unit 11 executes various functions.

The input unit 12 is so provided as to allow inputting of a command to the control unit 11. The input unit 12 includes at least one of a touch screen, a keyboard, a mouse, a touch pad, a button, and a rotary knob, for example. For example, when the input unit 12 is the touch screen, the input unit 12 and the display unit 13 may be an integrated unit. The integrated unit may also include the control unit 11.

The display unit 13, under the control of the control unit 11, displays a screen that displays various information related to the management system 100, and an entry screen for giving the command to the control unit 11. The display unit 13 is composed of, for example, a liquid crystal panel or an organic EL panel. The display unit 13 may include the touch screen, in which case the display unit 13 doubles as the input unit 12, as described above.

### <3. Screen Display of Display Unit>

Next, a display on the screen of the display unit 13 will be described in detail.

### (3-1. Overview of Screen Display)

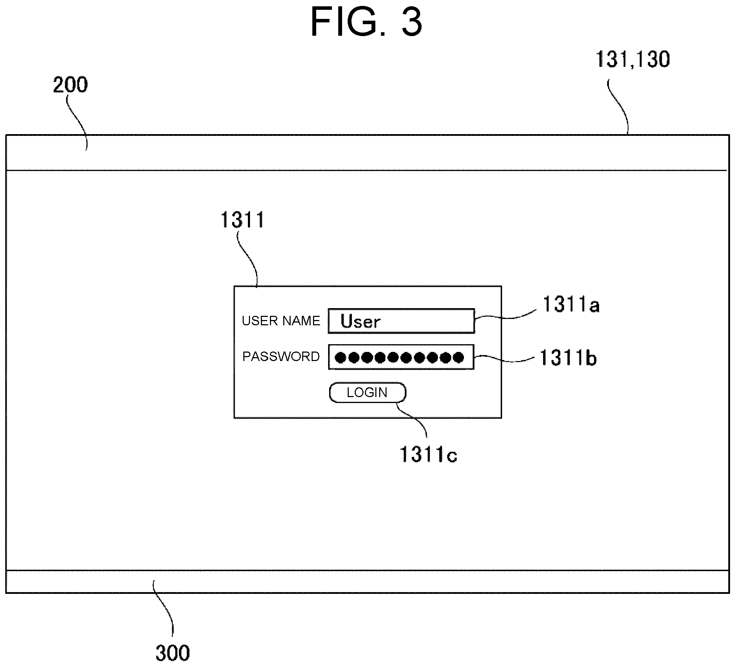

Fig. 3 shows a schematic diagram showing a state of displaying a login screen 131 on a screen 130 of the display unit 13. A person (user) who attempts to access the management system 100 is first required to enter predetermined information on the login screen 131. That is, the screen for displaying various information related to the management system 100, the entry screen for entering the command to the control unit 11, and the like cannot be viewed without the user entering necessary information in the login screen 131.

In the present embodiment, as shown in Fig. 3, the login screen 131 has a login information entry area 1311. The login information entry area 1311 has a user name entry area 1311a for entering the user name, a password entry area 1311b for entering a password preliminarily associated with the user name, and a login button 1311c. That is, on the login screen 131, the user is required to enter the user name and the password.

The user name and the password are entered using, for example, the keyboard or the touch screen. In a configuration using the touch screen or mouse for entering, it may be so configured that the entering is executed using a software keyboard (virtual keyboard) that appears within the login screen 131. The software keyboard may be, for example, so configured as to appear in the login screen 131 when the user touches or clicks the user name entry area 1311a or the password entry area 1311b. A similar software keyboard may be used to enter letters and numbers on any type of screen other than the login screen 131.

In the present embodiment, the top end portion of the login screen 131 has a header area 200 that extends in the right/left direction of the screen 130. In addition, the bottom end portion of the login screen 131 has a footer area 300 that extends in the right/left direction of the screen 130. The header area 200 and the footer area 300 are properly displayed on any type of screen other than the login screen 131. The header area 200 displays, for example, a company logo, a menu related to the screen display, and the like. The footer area 300 displays, for example, time, a user name allowed to log in, and the like.

Operating the login button 1311c by touch or the like after the user name and the password are entered displays a home screen 132. When at least one of the user name and the password is improper, an error message is displayed on the login screen 131, failing to display the home screen 132.

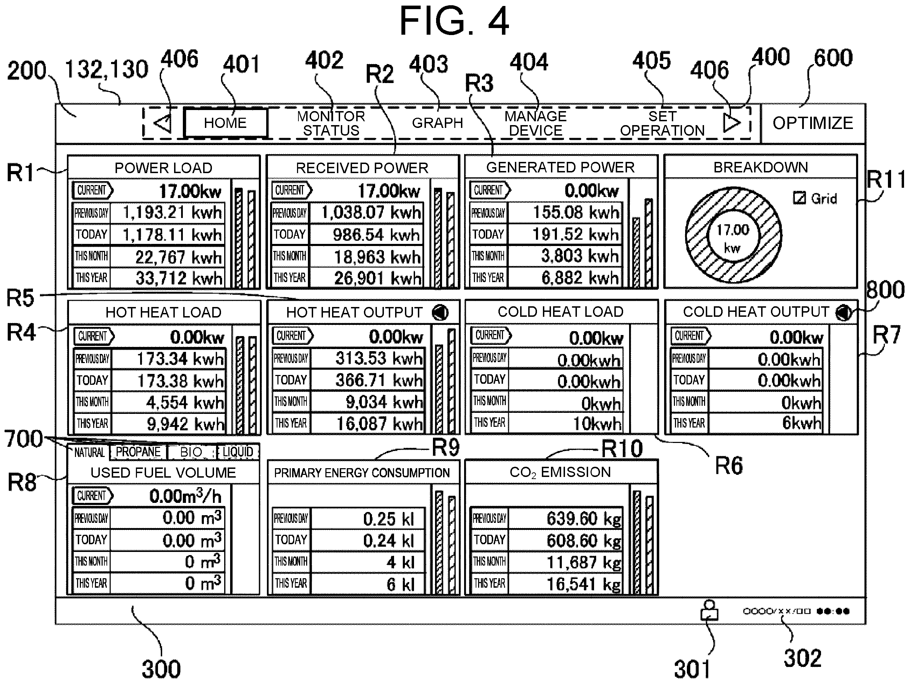

Fig. 4 is a schematic diagram showing a state of displaying the home screen 132 on the screen 130 of the display unit 13. In the present embodiment, the home screen 132 is a screen designed to allow the supply and demand of the electric energy and heat energy in the management system 100 to be viewed at a glance. In the example shown in Fig. 4, the home screen 132 has the header area 200. The header area 200 includes a menu area 400 that shows the type of screen display that can be selected. In the present embodiment, the menu area 400 includes a home button 401, a status monitoring button 402, a graph button 403, a device management button 404, and an operation setting button 405. The touch screen, mouse, or keyboard, for example, may be used to operate each of the buttons 401 to 405.

In the example shown in Fig. 4, the home screen 132 is in a selected state, so a selection display is provided to show the above selected state. In detail, a frame surrounding the home button 401 is displayed as the selection display. However, the selection display is not limited to the frame surrounding the button, but may be configured otherwise, such as a configuration of making a button different in color from another button, or a configuration of making a button different in hatching from another button.

Selecting the status monitoring button 402 displays a status monitoring screen. The status monitoring screen displays details of an operating status of each device included in the management system 100. Each device includes the heat and electric devices. The heat device includes, for example, the heat-related facility described above (including a facility that is used also for the electricity-related facility) and the heat load (air conditioning facility, footbath facility, etc.). The electric device includes, for example, the electricity-related facility (including a facility that is used also for heat-related facility) and the power load described above.

Selecting the graph button 403 displays a graph screen. The graph screen displays, for example, a graph or the like showing the shift in magnitude of the hourly heat and power loads for one day as well as a breakdown of each device's output relative to the load.

Selecting the device management button 404 displays a device management screen. The device management screen displays device management information including input/output information of each device.

Selecting the operation setting button 405 displays an operation setting screen. The operation setting screen includes an entry screen for entering information related to the operation of the management system 100. The information related to the operation includes information about the control method of the management system 100. In the present embodiment, it is so configured that the operation setting screen can select whether an optimization control and a demand control are enabled or disabled.

The optimization control is a control method in which control is executed according to an optimization target selected by the user (typical example is a customer) using the management system 100. The optimization targets include, for example, the cost priority which prioritizes the reduction of various fees borne by the user, the carbon dioxide emission priority which prioritizes the reduction of carbon dioxide emission generated by the device operation, and the primary energy consumption priority which prioritizes the reduction of primary energy consumption required for the device operation. In the present embodiment, the user can select any one of these three optimization targets. The user, when selecting the cost priority, executes the operation control prioritizing the cost reduction, assuming that the optimization control is set to be enabled. The user, when selecting the carbon dioxide emission priority, executes the operation control prioritizing the reduction of carbon dioxide emission, assuming that the optimization control is set to be enabled. The user, when selecting the primary energy consumption priority, executes the operation control prioritizing the reduction of primary energy consumption, assuming that the optimization control is set to be enabled.

The demand control is a control method that so controls the device included in the management system 100 that the power received from the power system 10 does not exceed the target demand value. The target demand value is set at the contract power or less. When the optimization control and the demand control are set to be enabled, in principle, the management system 100 operates by the optimization control, and when the power received approaches the target demand value, the management system 100 switches to the demand control.

As can be seen from the above description, the display unit 13 can display the information, which is managed by the management system 100, by switching to multiple types of screens. In the example shown in Fig. 4, it is possible to switch to at least five different screens including the home screen, the status monitoring screen, the graph screen, the device management screen, and the operation setting screen. However, these screen displays are merely an exemplification, and the types of screens that can be displayed by the display unit 13 may be changed as needed.

In the example shown in Fig. 4, the menu area 400 includes a feed button 406. Operating the feed button 406 by touch or the like switches the type of screen type selection button displayed in the menu area 400. That is, the example shown in Fig. 4 can display any screen other than the five types including the home screen, the status monitoring screen, the graph screen, the device management screen, and the operation setting screen. Examples of screens other than the five types described above include a user management screen for entering user information, and a screen setting screen for setting a screen-related condition.

In the example shown in Fig. 4, the home screen 132 has the footer area 300. The footer area 300 includes an icon area 301 showing the user name and a time information area 302 including date and time. In the present embodiment, operating the icon area 301 by touch or the like can execute logout. As a preferred configuration, operating the icon area 301 displays a confirmation screen on the screen in a pop-up manner to confirm whether or not the logout may be executed, and the confirmation screen allowing the logout executes the logout.

### (3-2. Details of Home Screen)

Next, the home screen 132 shown in Fig. 4 is explained in detail. The home screen 132 displays plural pieces of information that are managed by the management system 100 and that are related to power and heat. In other words, on the display unit 13, the plural pieces of information that are in the management system 100 and that is related to power and heat are displayed on a single screen. With this configuration, the user, by viewing the single screen, can grasp the information that is in the management system 100 and that is related to power and heat. That is, user convenience can be improved. The plural pieces of information related to power and heat are preferably displayed in respectively separate areas on the single screen. In detail, in separate areas, the home screen 132 lists pieces of energy information that are managed by the management system 100 and that include power load information, received power information, generated power information, and heat load information. In other words, on the display unit 13, pieces of energy information that are in the management system 100 and that include the power load information, the received power information, the generated power information, the heat load information, and the heat output information are displayed in separate areas on the single screen. With this configuration, the user, by viewing the single screen, can grasp the load information and output information about the power and heat in the management system 100. That is, user convenience can be improved.

In the present embodiment, the heat load includes both hot heat load and cold heat load, and the heat output includes both hot heat output and cold heat output. However, this is merely an exemplification, and the heat load can be any of the hot heat load and cold heat load, and correspondingly, the heat output may be any of hot heat output and cold heat output. The heat load in the home screen 132 is a demand volume for the hot heat in a device that uses the hot heat (e.g., heating device), and the cold heat load is a demand volume for the cold heat in a device that uses the cold heat (e.g., cooling device). The hot heat output is the output of the device (e.g., boiler 4) that supplies the hot heat. There may be a single or multiple facilities supplying the hot heat. The cold heat output is the output of the device (e.g., 5 heat pumps) that supplies the cold heat. There may be a single or multiple facilities supplying the cold heat.

The received power is power purchased from the power system 10. The generated power is power generated by power generation facility that is possessed by the management system 100 and that includes the renewable energy generating unit 2 and the cogeneration system 7, for example.

In detail, the home screen 132 includes a power load display area R1, a received power display area R2, a generated power display area R3, a hot heat load display area R4, a hot heat output display area R5, a cold heat load display area R6, and a cold heat output display area R7. In the present embodiment, the display areas R1 to R7 are each rectangular in shape. However, the shape of each of the display areas R1 to R7 may be any other shape, such as an oval.

In the present embodiment, the power load display area R1, the received power display area R2, and the generated power display area R3, which are display areas related to power, are lined up along the right/left direction of the screen 130. In addition, the hot heat load display area R4, the hot heat output display area R5, the cold heat load display area R6, and the cold heat output display R7, which are display areas related to heat, are lined up along the right/left direction of the screen 130. The display areas R1, R2, and R3 related to power, are placed above the display areas R4, R5, R6, and R7 related to heat. However, these are merely exemplifications. For example, the display areas R1, R2, and R3 related to power may be placed below the display areas R4, R5, R6, and R7 related to heat. The configuration may also be not grouped into the power and the heat. The display areas R1, R2, and R3 related to the power and R4, R5, R6, and R7 related to the heat may be lined up in the vertical direction, respectively. Further, it may be so configured that each of the display areas R1 to R7 can be rearranged according to the user's preference.

At least one of the plural areas is preferably configured to display plural types of information with different collection periods. It is also preferred that the plural types of information described above include today's information and previous day's information.

In the present embodiment, the plural display areas R1 to R7 each display plural types of information with different collection periods. In detail, display modes of the plural types of information with different collection periods are the same as each other among the plural display areas R1 to R7. However, in at least one of the display areas R1 to R7, the display modes of the plural types of information with different collection periods may be different from any other display area.

In detail, each of the display areas R1 to R7 shows a current value, a previous day's value, today's value, this month's value, and this year's value. The current value is an instantaneous value at the current time. The previous day's value is a cumulative value of the previous day. Today's value is a cumulative value from today's start time to the current time. This month's value is a cumulative value from this month's start time to the current time. This year's value is a cumulative value from this year's start time to the current time.

In the present embodiment, it is so configured that each of the display areas R1 to R7 displays five types of information with different collection periods (current value, previous day's value, today's value, this month's value, and this year's value), but this is an exemplification. The type and number of the pieces of the above information may be properly changed. For example, this week's value may be increased or this year's value may be changed to this week's value, as the type of information.

It is preferable that at least one of the areas is configured to display numerical information and graph information. However, it is sufficient that at least one of the areas is configured to display at least one of the numerical information and the graph information.

In the present embodiment, each of the display areas R1 to R7 displays the numerical information and the graph information. However, it may be so configured that only a part of the display areas R1 to R7 displays the numerical information and the graph information. In the present embodiment, in detail, in each of the display areas R1 to R7, five types of numerical information are displayed as described above: the current value, the previous day's value, today's value, this month's value, and this year's value. In each of the display areas R1 to R7, two types of graph information are displayed: the previous day's value and today's value. However, the type and number of pieces of graph information to be displayed may be properly changed.

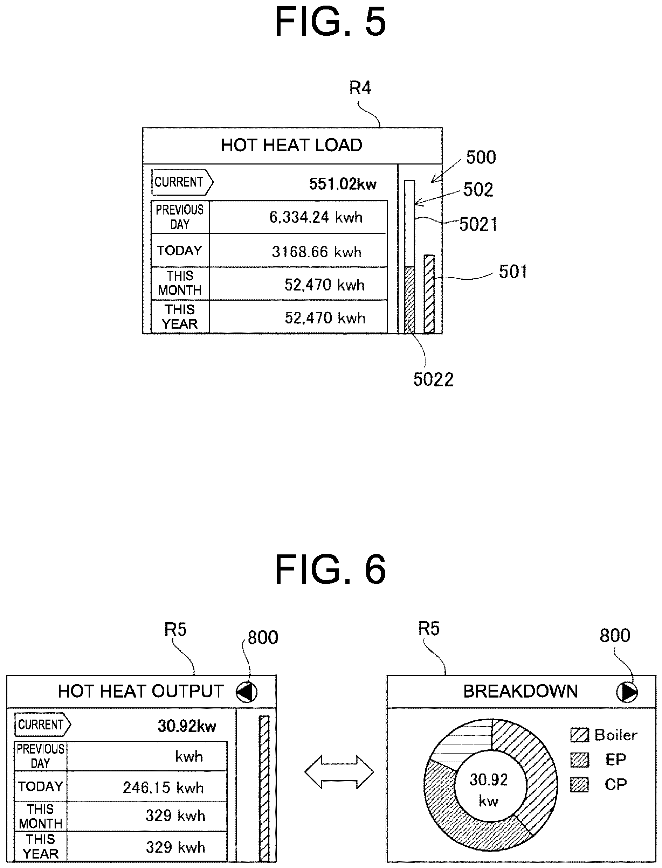

It is preferable that at least one of the areas is configured to display a bar graph that includes today's information and the previous day's information. Fig. 5 explains details of the graph information displayed in each of the display areas R1 to R7. Fig. 5 extracts and shows the hot heat load display area R4 as a representative example. The composition of the graph information in the other display areas R1 to R3 and R5 to R7 is the same as in the hot heat load display area R4. A display content of the hot heat load display area R4 shown in Fig. 5 is different from that of the hot heat load display area R4 shown in Fig. 4. This is because the timing of the screen display is different between Fig. 4 and Fig. 5.

As shown in Fig. 5, the hot heat load display area R4 displays a bar graph 500 that includes a bar portion 501 showing today's information, and a bar graph 500 that includes a bar portion 502 showing the previous day's information. The bar portion 501, which shows today's information, shows the cumulative value from today's start time to the current time. Today's start time is 00:00. The bar portion 502, which shows the previous day's information, includes a first bar portion 5021 and a second bar portion 5022. The first bar portion 5021 shows the cumulative value of the previous one day. The second bar portion 5022 is distinguishably displayed overlapping the first bar portion 5021, and shows a cumulative value from the previous day's start time to the previous day's current time (same as today's current time).

In the present embodiment, the first bar portion 5021 is shown in white, and the second bar portion 5022 is shown with hatching, making it possible to distinguish the first bar portion 5021 from the second bar portion 5022. However, any other display method may be used, as long as the two can be distinguished when overlapped.

In the present embodiment, as a preferred mode, the plural pieces of information that are displayed on the home screen 132 (single screen) and that are related to power and heat further include used fuel volume information showing used fuel volume in the management system 100.

In detail, as shown in Fig. 4, the home screen 132 includes a used fuel volume display area R8. The used fuel volume display area R8 is rectangular in shape like the other display areas R1 to R7, but the above shape may be properly changed. In the used fuel volume display area R8, plural types of information with different collection periods are also displayed, and the display mode is the same as in the other display areas R1 to R7. That is, the used fuel volume display area R8 shows the current value, the previous day's value, today's value, this month's value, and this year's value. The used fuel volume display area R8 also displays the bar graph 500. However, the above display mode may be properly changed, like the display areas R1 to R7 above. In the present embodiment, the used fuel volume display area R8 is placed below the hot heat load display area R4, but this placement may be properly changed.

In the present embodiment, as a preferred mode, the area displaying the used fuel volume information is displayable in a manner to switch information for each type of the fuel.

In detail, a fuel type switch button 700 is displayed above the used fuel volume display area R8. In the present embodiment, four types of buttons are displayed: natural gas, propane gas, biogas, and liquid fuel. Operating by touch or the like any of the four types of fuel type switch buttons 700 displays the used volume information for the corresponding fuel. In the present embodiment, it is so configured that four types of fuel type switch buttons 700 are displayed, but the type and number of buttons may be properly changed.

Further, in the present embodiment, as a preferred mode, the plural pieces of information that are displayed on the home screen 132 (single screen) and that are related to power and heat further include at least one of energy consumption information showing energy consumption in the management system 100, and carbon dioxide emission volume information showing carbon dioxide emission volume in the management system 100.

In detail, as shown in Fig. 4, the home screen 132 includes a primary energy consumption display area R9 and a carbon dioxide (CO₂) emission volume display area R10. These display areas R9 and R10 are rectangular in shape like the other display areas R1 to R8 described above, but the above shape may be properly changed. In these display areas R9 and R10, plural types of information with different collection periods are also displayed, and their display modes are generally the same as in the other display areas R1 to R8. However, the current value is not displayed. That is, the primary energy consumption display area R9 and the carbon dioxide emission volume display area R10 display the previous day's value, today's value, this month's value, and this year's value. In addition, the primary energy consumption display area R9 and the carbon dioxide emission volume display area R10 display the bar graph 500. However, these display modes may be properly changed, like the display areas R1 to R8 described above. In the present embodiment, the primary energy consumption display area R9 is placed below the hot heat output display area R5, and the carbon dioxide emission volume display area R10 is placed below the cold heat load display area R6, but these placements may be properly changed.

In the present embodiment, as a preferred mode, the home screen 132 further includes a control state display area 600 that shows the control state of the management system 100.

As shown in Fig. 4, in the embodiment, the control state display area 600 is included in the header area 200. In detail, the control state display area 600 is placed to the right of the menu area 400. However, the control state display area 600 may be displayed elsewhere on the home screen 132 as long as being in an easily viewable position. In the example shown in Fig. 4, the control state display area 600 displays "Optimize". This shows that the management system 100 is being operated under the optimization control described above. In addition to this, "Demand Control", "Stopped", etc. are displayed in the control state display area 600, for example.

In addition, the pieces of energy information displayed in respectively separate areas on the home screen 132 (single screen) include power breakdown information that shows the breakdown of sources of the power supplied to the power load. In detail, the home screen 132 includes a power breakdown display area R11. In the present embodiment, the power breakdown display area R11 is displayed in the right/left direction together with the power load display area R1, the received power display area R2, and the and the generated power display area R3. However, the position at which the power breakdown display area R11 is placed on the home screen 132 may be properly changed.

In detail, as shown in Fig. 4, the power breakdown display area R11 uses a circular graph thereby to show the breakdown of power sources. The breakdown shown in the circular graph is a breakdown of the current power sources. However, the breakdown of the current power sources may be displayed by using any other graph, such as a band graph, not limited to the circular graph. The breakdown may also be displayed in a table format. The breakdown displayed in the circular graph is not limited to the breakdown of the current power, but may be a breakdown of the power (power amount) up to today's current time, for example. In the example shown in Fig. 4, all of the power loads is covered by the received power, so the power breakdown shown in the circular graph is only for the power system (denoted as Grid in the drawing).

In the present embodiment, at least one of the plural areas is so provided as to display a graph, which shows the breakdown of the energy sources, in a manner to be switched with other information.

In detail, of the plural display areas R1 to R11, the hot heat output display area R5 and the cold heat output display area R7 are so provided that a graph showing the breakdown of the energy sources can be displayed in a manner to be switched with other information. The hot heat output display area R5 and the cold heat output display area R7 each display a display switch button 800. Operating the display switch button 800 by touch or the like switches the display.

Fig. 6 explains about an operation of the display switch buttons 800 displayed in the hot and cold heat output display areas R5, R7. The display switch button 800's operations in the hot heat output display area R5 and cold heat output display area R7 are the same, so Fig. 6 shows the case in the hot heat output display area R5 as a representative example. The display content of the hot heat output display area R5 shown in Fig. 6 is different from that of the hot heat output display area R5 shown in Fig. 4. This is because the timing of the screen display is different between Fig. 4 and Fig. 6. The display mode and placement of the display switch button 800 shown in Fig. 6 are exemplifications, which may be properly changed.

When the numeric information of the current heat output is displayed in the hot heat output display area R5 (display state shown on the left side in Fig. 6), operating the display switch button 800 brings about a state displaying a circular graph showing the breakdown of the current hot heat output sources (display state shown on the right side in Fig. 6). In the state where the circular graph showing the breakdown of the current hot heat output sources is displayed in the hot heat output display area R5 (display state shown on the right side in Fig. 6), operating the display switch button 800 returns to the state where the numerical information on the current heat output is displayed (display state shown on the left side in Fig. 6).

In the example shown in Fig. 6, the breakdown of the current hot heat output sources includes the boiler (denoted as Boiler in the drawing), a first cogeneration system (denoted as EP in the drawing), and a second cogeneration system (denoted as CP in the drawing). In this example, the breakdown is shown by the circular graph, but not limited to this, the breakdown can also be shown in a band graph or the like.

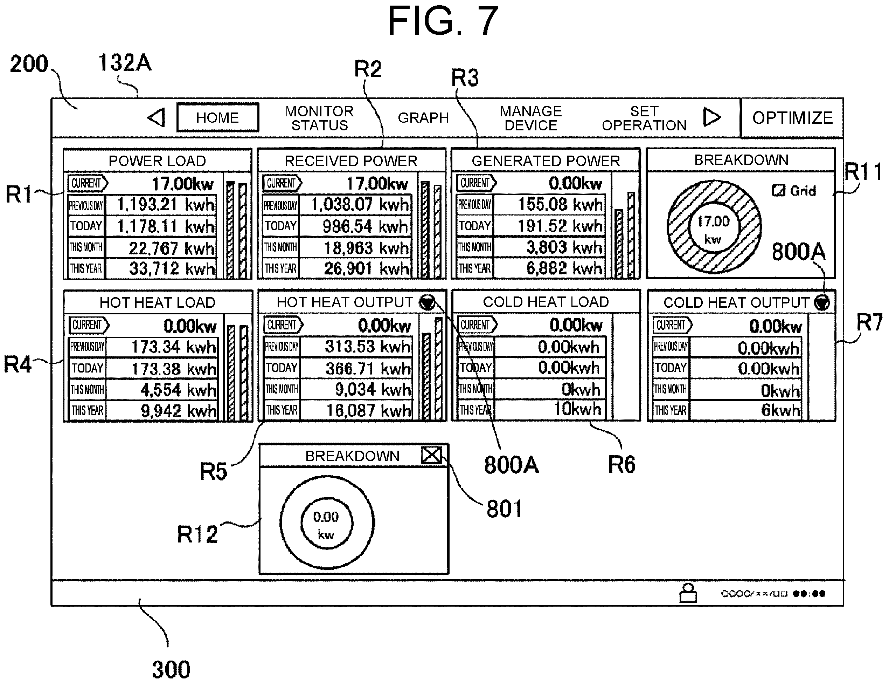

In the present embodiment, it is so configured as to switch the display in the display areas R5 and R7, but this is merely an exemplification. As shown in Fig. 7, it may be so configured that, when a request is made to display a graph showing the breakdown of the energy sources, some display areas is deleted and a display area displaying a graph showing the breakdown of the energy sources appears in a space left by the deleting.

Fig. 7 is a schematic diagram to explain about a home screen 132A of a modified example. In the example shown in Fig. 7, operating a display switch button 800A in the hot heat output display area R5 deletes the display areas R8, R9, and R10 (see Fig. 4) below the home screen 132A. Then, in the space vacated by the deleting, a breakdown display area R12 is displayed, which shows a circular graph showing the breakdown of the hot heat output sources. By touch or the like, operating a deletion button 801 displayed in the breakdown display area R12 deletes the breakdown display area R12. Deleting the breakdown display area R12 displays the display areas R8 to R10 that were displayed before the displaying of the breakdown display area R12. The same operation is also obtained when the display switch button 800A in the cold heat output display area R7 is operated.

In the example shown in Fig. 7, it is so configured that operating the display switch button 800 deletes all of the three display areas R8 to R10 displayed below; however, it may be so configured that only a part of the display areas below is deleted, as long as the space for displaying the breakdown display area R12 can be secured. A part of the display areas may be, for example, the primary energy consumption display area R9 placed below the hot heat output display area R5. A part of the display areas deleted so as to secure the display space of the breakdown display area R12 may be so configured as to be setting-changed according to the user's preference, for example.

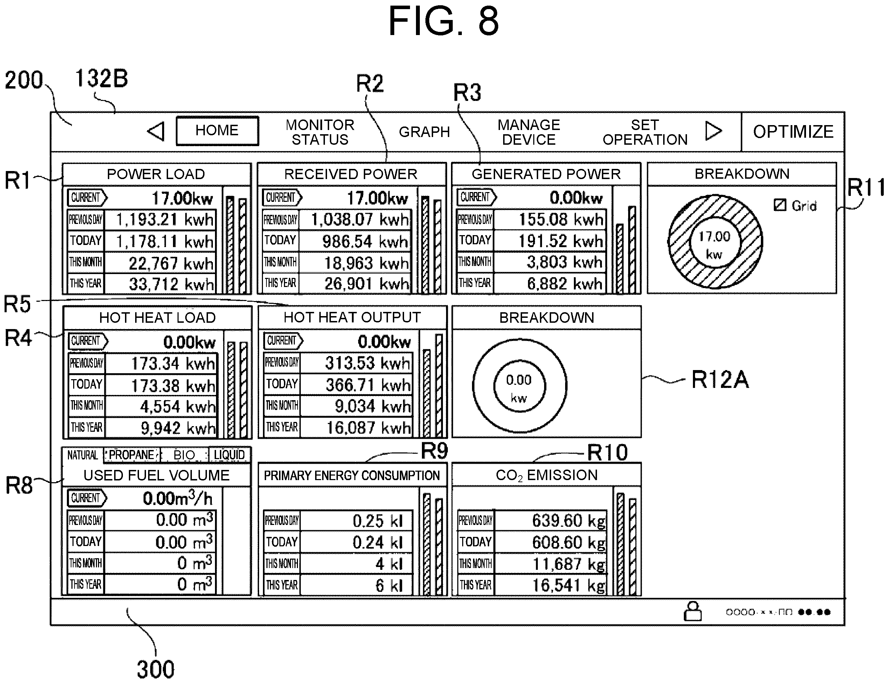

When it is so configured that, in the management system 100, only one of the heat load and the cold heat load is assumed, only one of the two displays, the one for the hot heat and the other for the cold heat, may be displayed on the home screen 132. In such a case, as shown in Fig. 8, due to room made for the display space, it may be so configured that a breakdown display area R12A, which shows the breakdown of heat output sources, is displayed in a home screen 132B from the beginning.

Fig. 8 is a schematic diagram to explain about a home screen 132B of another modified example. The home screen 132B shown in Fig. 8 is so configured that the hot heat load display area R4 and the hot heat output display area R5 are displayed, and the cold heat load display area R6 and the cold heat output display area R7 are not displayed. The breakdown display area R12A is placed right next to the hot heat output display area R5. The content displayed in the breakdown display area R12A may be displayed in the hot heat output display area R5. That is, it may be so configured that some of the plural areas display a graph showing the breakdown of the energy sources alongside any other information.

### <4. Notes, etc.>

The various technical features disclosed in the present specification can be modified in various ways without departing from the gist of the technical creation thereof. Further, the multiple embodiments and modified examples shown in the present specification may be combined to the extent possible.

### REFERENCE SIGNS LIST

13: display unit
100: management system
130: screen
132, 132A, 132B: home screen (single screen)
500: bar graph
501, 502: bar portion
600: control state display area
5021: first bar portion
5022: second bar portion
R1 to R12: area

## Claims

1. A display unit possessed by a management system that manages energy,
wherein plural pieces of information in the management system and related to power and heat are displayed on a single screen.

2. The display unit as claimed in claim 1, wherein
the plural pieces of the information related to the power and the heat are displayed in respectively separate areas on the single screen.

3. The display unit as claimed in claim 2, wherein
at least one of the plural areas displays plural types of information with different collection periods.

4. The display unit as claimed in claim 2 or 3, wherein
an area of the areas displays numerical information and graph information.

5. The display unit as claimed in claim 3, wherein
the plural types of the information include today's information and previous day's information.

6. The display unit as claimed in claim 5, wherein
an area of the areas displays a bar graph including the today's information and the previous day's information.

7. The display unit as claimed in claim 6, wherein
a bar portion, which shows the today's information, shows a cumulative value from today's start time to current time.

8. The display unit as claimed in claim 6 or 7, wherein
a bar portion, which shows the previous day's information, includes:
a first bar portion which shows a cumulative value of previous one day, and
a second bar portion which is distinguishably displayed overlapping the first bar portion, and which shows a cumulative value from previous day's start time to the previous day's time which is the same as the today's current time.

9. The display unit as claimed in any one of claims 2 to 8, wherein
at least one of the plural areas is capable of displaying a graph, which shows a breakdown of an energy source, in a manner to be switched with other information.

10. The display unit claimed in any one of claims 2 to 9, wherein
the plural pieces of the information related to the power and the heat further include used fuel volume information showing used fuel volume in the management system.

11. The display unit as claimed in claim 10, wherein
an area of the areas displaying the used fuel volume information is displayable in a manner to switch information for each type of the fuel.

12. The display unit as claimed in any one of claims 1 to 11, wherein
the plural pieces of the information related to the power and the heat further include at least one of energy consumption information showing energy consumption in the management system, and carbon dioxide emission volume information showing carbon dioxide emission volume in the management system.

13. The display unit as claimed in any one of claims 1 to 12, wherein
the single screen further includes a control state display area showing a control state of the management system.
